## Europäisches Patentamt

## European Patent Office

## Office européen des brevets

(19)

(11) Veröffentlichungsnummer: **0 103 067**
**B1**

(12) # EUROPÄISCHE PATENTSCHRIFT

(45) Veröffentlichungstag der Patentschrift:
**04.01.89**

(21) Anmeldenummer: **83104871.5**

(22) Anmeldetag: **17.05.83**

(51) Int. Cl.⁴: **H 01 L 23/40, H 01 L 23/12**

(54) Einrichtung zum Kühlen einer Mehrzahl von zu Flachbaugruppen zusammengefassten integrierten Bausteinen.

(30) Priorität: **09.09.82 DE 3233522**

(43) Veröffentlichungstag der Anmeldung:
**21.03.84 Patentblatt 84/12**

(45) Bekanntmachung des Hinweises auf die Patenterteilung:
**04.01.89 Patentblatt 89/1**

(84) Benannte Vertragsstaaten:
**AT BE CH DE FR GB IT LI NL**

(56) Entgegenhaltungen:
**EP-A-0 000 244**

**PATENTS ABSTRACTS OF JAPAN, Band 6, Nr. 151 (E-124) 1029 , 11. August 1982**
**IBM TECHNICAL DISCLOSURE BULLETIN, Band 21, Nr. 3, August 1978, Seiten 1064-1065, Armonk, New York, US; R.D. DURAND et al.: "Ceramic cap and heat sink for semiconductor package"**
**IBM TECHNICAL DISCLOSURE BULLETIN, Band 20, Nr. 12, Mai 1978, Seiten 5142-5143, Armonk, New York, US; J.D. LARNERD: "IC PACKAGE ASSEMBLY"**
**IBM TECHNICAL DISCLOSURE BULLETIN, Band 8, Nr. 3, August 1965, Seite 380, Armonk, New York, US; L.F. MILLER: "Microelectronic device standoffs"**
**PATENTS ABSTRACTS OF JAPAN, Band 8, Nr. 66 (E-234) 1503 , 28 März 1984**

(73) Patentinhaber: **Siemens Aktiengesellschaft Berlin und München, Wittelsbacherplatz 2, D-8000 München 2 (DE)**

(72) Erfinder: **Wessely, Herrmann, Dipl.- Ing., Paul-Hösch- Strasse 1, D-8000 München 60 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung bezieht sich auf eine Einrichtung zum Kühlen einer Mehrzahl von zu Flachbaugruppen zusammengefaßten integrierten Bauteilen gemäß dem Oberbegriff des Anspruchs 1. Eine solche Einrichtung ist aus dem Patent Abstracts of Japan, Band 6, Nr 151 (E-124) [1029], 11. August 82, bekannt.

Die zunehmende Miniaturisierung von integrierten Bausteinen zu sogenannten hochintegrierten Bausteinen und in Verbindung damit die hohe Packungsdichte haben eine starke Wärmeabgabe derjenigen Flachbaugruppe zur Folge, die mit einer Mehrzahl solcher integrierter Bausteine bestückt sind, was leicht zu einer Überschreitung der für die integrierten Bausteine zulässigen Temperaturen führen kann. Zu ihrem Schutz werden deshalb derartige Flachbalgruppen mit einen oder auch mehreren Kühlkörpern versehen.

Es ist bekannt, für derartige Flachbaugruppen großflächige Metallplatten als Kühlkörper zu verwenden, die die Abwärme der integrierten Bausteine entweder an die sie umgebende Luft oder an flüssigkeits- oder gasdurchströmte Hohlkörper abgeben. So ist z. B aus den US-Patent 3 993 123 eine Einrichtung mit einer Mehrzahl von wärmeerzeugenden elektrischen Bausteinen bekannt, die auf einer Unterlage montiert sind. Ein Wärmeableitgehäuse versiegelt und umschließt die wärmeerzeugenden Bauelemente. Die der Unterlage gegenüberliegende Wand des Gehäuses besitzt langgestreckte zylinderförmige Öffnungen in Richtung auf die wärmeerzeugenden Bauelemente zu. In jeder derartigen Öffnung des Gehäuses befindet sich ein Federelement, das sich gegen daß innere Ende der Öffnung abstützt. Außerdem befindet sich in jeder Öffnung ein wärmeleitendes Element in Form eines Kolbens, der so dimensioniert ist, daß nur ein schmaler Spalt zwischen den äußeren Wänden der Öffnungen und dem Kolben bleibt. Jedes Federelement drückt das Wärmeleitelement gegen eines der wärmeerzeugenden Bauelemente. Ein wärmeleitendes inertes Fluidium befindet sich im Inneren des Gehäuses und füllt alle Spalte und Leerräume desselben aus. Die Wärme wird von dem Gehäuse durch externe Ableitmittel abgeleitet. Durch derartige Maßnahmen oder durch Maßnahmen, wie sie aus der europäischen Patentanmeldung 1 153 als Weiterterbildung dieser allgemeinen Idee bekannt sind, wird jeder einzelne elektronische Baustein individuell gekühlt. Nachteilig bei dieser Art von Kühleinrichtung ist jedoch, daß die Wärme von den Chip des integrierten Bausteins nur über punktförmige Kontakte in den Stempel und von dort über eine Gasstrecke in den eigentlichen Kühlkörper fließt. Der punktförmige Kontakt zwischen integriertem Baustein und Metallstempel und die Gasstrecke zwischen Metallstempel und Kühlkörper haben einen relativ hohen Wärmewiderstand. Außerdem erfordert der Aufbau einen großen Aufwand.

Der vorliegenden Erfindung lag daher die Aufgabe zugrunde, eine Einrichtung zum Kühlen derartiger integrierter Bausteine zu schaffen, die zum einen einen wesentlich geringeren Wärmewiderstand besitzt und deshalb eine deutlich bessere Kühlung der integrierten Bausteine mit sich bringt und die außerdem einen wesentlich geringeren Aufwand erfordert. Erfindungsgemäß wird dies dadurch erreicht, daß die Leiterplatte flexibel ist und die flexible Leiterplatte durch über ihre gesamte Fläche wirkende Andruckmittel mit den integrierten Bausteinen gegen die Kühlplatte gedrückt wird und der Andruck der einzelnen integrierten Bausteine an die gemeinsame Kühlplatte durch jeweils zwischen flexiblen Leiterplatte und integriertem Baustein eingefügte federnde Elemente erfolgt. Durch Zwischenfügen von Leitfett zwischen die integrierten Bausteine einerseits und die Kühlplatte andererseits kann der Wärmewiderstand der Einrichtung weiter gesenkt werden.

Weitere Ausgestaltungen der erfindungsgemäßen Einrichtungen ergeben sich aus den Unteransprüchen sowie aus der nachfolgenden Beschreibung von vorteilhaften Ausführungsbeispielen der erfindungsgemäßen Einrichtung anhand der Figuren.

Fig. 1 zeigt den prinzipiellen Aufbau einer erfindungsgemäßen Kuhleinrichtung,
Fig. 2 die Anordnung von elastischem Füllmaterial zwischen den einzelnen integrierten Bausteine.

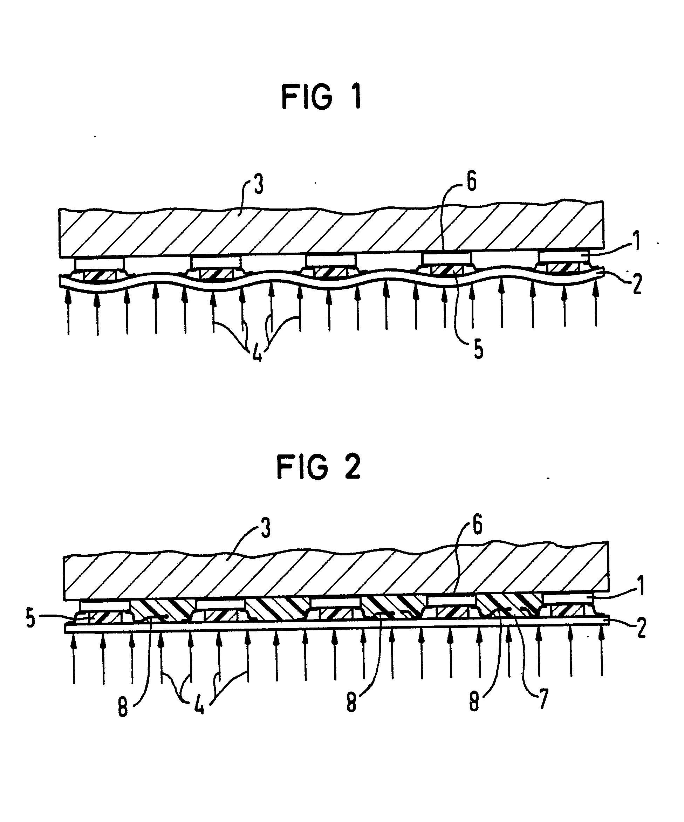

Fig. 1 zeigt eine Mehrzahl von integrierten Bausteinen die auf einer flexiblen Leiterplatte 2 zu einer Flachbaugruppe zusammengefaßt sind. Weiterhin ist ersichtlich, daß die integrierten Bausteine 1, die gehäuselos sind, auf ihrer gesamten Rückfläche mit einer allen integrierten Bausteinen gemeinsamen Kühlplatte 3 in Kontakt stehen. Diese gemeinsame Kühlplatte 3 ist von sehr hoher Ebenheit. Durch einen flächig wirkenden Andruck 4, z. B. in Form einer Vielzahl von Federn oder eines gasförmigen Mediums, wird die flexible Leiterptatte 2 zusammen mit den integrierten Bausteinen 1 gegen die gemeinsame Kühlplatte 3 großer Ebenheit gedrückt. Eine flexible Leiterplatte 2 gewährt zwar schon ein recht gutes Andrücken der einzelnen integrierten Bausteine 1. Um jedoch den Effekt noch zu verstärken, werden die einzelnen integrierten Bausteine 1 an die gemeinsame Kühlplatte 3 noch individuell angedrückt, indem jeweils zwischen starrer Leiterplatte 2 und integriertem Baustein 1 federnde Elemente angeordnet sind.

Fig. 1 und 2 zeigen ein mögliches Ausführungsbeispiel für derartig federnde Elemente, hier in Form eines federnden Füllstückes 5 zwischen integriertem Baustein 1 und Leiterplatte 2. Das federnde Füllstück 5 besteht vorteilhafterweise aus Gummi und die Anschlüsse der integrierten Bausteine 1 sind so ausgebildet, daß sie keine Kräfte aufnehmen können. Die federnden Füllstücke 5 bewirken, daß die auf die flexible Leiterplatte flächig ausgeübte Kraft 4 jedem einzelnen integrierten Baustein individuell zugeführt wird und somit jeden integrierten Baustein sicher an die gemeinsame Kühlplatte 3 andrücken.

Um den an sich schon sehr geringen Wärmewiderstand der erfindungsgemäßen Einrichtung noch weiter zu verringern, ist es vorteilhaft, zwischen die integrierten Bausteine 1 und die gemeinsame Kühlplatte 3 jeweils Leitfett 6 einzufügen.

Je nach Flexibilität der flexiblen Leiterplatte und Größe der Flächenbelastung wird die gedruckte Schaltung mehr oder weniger stark verformt, was zu einer Beschädigung der Schaltung führen kann. Um dies zu vermeiden, sind gemäß einer vorteilhaften Weiterbildung der erfindungsgemäßen Einrichtung die in der Umgebung der integrierten Bausteine 1 befindlichen Zwischenräume zwischen flexibler Leiterplatte 2 und Kühlplatte 3 mit elastischem Füllmaterial 7 ausgefüllt. Als elastisches Füllmaterial kann z. B. Silikon vorgesehen werden, mit dem die Zwischenräume vergossen werden. Um die gesamte Einrichtung aber jederzeit zerlegen zu können, kann es vorteilhaft sein, dem elastischen Füllmaterial die Form von Schablonen zu geben, die zwischen die integrierten Bausteine 1 eingelegt werden.

Das Ausfüllen der Zwischenräume in der Umgebung der integrierten Bausteine 1 bewirkt, daß die flexible Leiterplatte 2 zwischen den einzelnen integrierten Bausteinen entlastet wird. Ferner bewirkt das elastische Füllmaterial, daß eventuell zwischen den integrierten Bausteinen 1 befindliche diskrete Verdrahtungen 8 mechanisch gehalten und ebenfalls gegen Beschädigungen geschützt werden.

**Patentansprüche**

1. Einrichtung zum Kühlen einer Mehrzahl von zu Flachbaugruppen zusammengefaßten gehäuselosen integrierten Bausteinen, die auf einer Leiterplatte angeordnet sind, wobei die gesamte Rückseite jedes integrierten Bausteins in Kontakt mit einer allen integrierten Bausteinen gemeinsamen Kühlplatte ist, dadurch gekennzeichnet, daß die Leierplatte flexibel ist und die flexible Leiterplatte durch über ihre gesamte Fläche wirkende Andruckmittel (4) mit den integrierten Bausteinen (1) gegen die Kühlplatte (3) gedrückt wird und der Andruck der einzelnen integrierten Bausteine (1) an die gemeinsame Kühlplatte (3) durch jeweils zwischen flexibler Leiter-Platte (2) und integriertem Baustein (1) eingefügte federnde Elemente (5) erfolgt.

2. Einrichtung nach Anspruch 1, dadurch gekennzeichnet, daß zwischen jedem integrierten Baustein und der flexiblen Leiterplatte ein federndes Füllstück (5) angeordnet ist.

3. Einrichtung nach Anspruch 2, dadurch gekennzeichnet, daß das federnde Füllstück (5) aus Gummi besteht.

4. Einrichtung nach einem der Ansprüche 1 bis 3, dadurch gekennzeichnet, daß zwischen den integrieten Bausteinen und der Kühlplatte Leitbetten (6) angeordnet ist.

5. Einrichtung nach einem der Ansprüche 1 bis 4, dadurch gekennzeichnet, daß die in der Umgebung der integrierten Bausteine (1) befindlichen Zwischenräume zwischen flexibler Leiterplatte (2) und Kühlplatte (3) mit elastischem Füllmaterial (7) ausgefüllt sind.

6. Einrichtung nach Anspruch 5, dadurch gekennzeichnet, daß als elastisches Füllmaterial Silikon vorgesehen ist.

7. Einrichtung nach Anspruch 5 oder 6, dadurch gekennzeichnet, daß das elastische Füllmaterial in Form elastischer Schablonen ausgeführt ist.

**Claims**

1. Cooling device for a plurality of intregrated components without housing assembled as a flat structure which are arranged on a circuit board, the entire rear surface of each integrated component being in contact with a cooling plate common to all the integrated components, characterized in that the circuit board is flexible and the flexible circuit board with the integrated components (1) is pressed against the cooling plate (3) by pressure means (4) acting over the entire surface of the circuit board and the individual integrated components (1) are pressed against the common cooling plate (3) by spring elements (5) inserted in each case between flexible circuit board (2) and integrated component (1).

2. Device according to Claim 1, characterized in that a spring falling piece (5) is arranged between each integrated component and the flexible circuit board.

3. Device according to Claim 2, characterized in that the spring filling piece (5) is made of rubber.

4. Device according to one of Claims 1 to 3, characterized in that conductive grease (6) is arranged between the integrated components and the cooling plate.

5. Device according to one of Claims 1 to 4, characterized in that the interspaces located in the vicinity of the integrated components (1) between the flexible circuit board (2) and cooling plate (3) are filled with resilient filling material (7).

6. Device according to Claim 5, characterized in that silicone is provided as the resilient filling material.

7. Device accrding to Claim 5 or 6, characterized in that the resilient filling material is designed in the form of resilient overlays.

## Revendications

1. Dispositif pour refroidir un certain nombre de composants intégrés rassemblés sans boîtiers en modules plats, les composants étant disposés sur une carte imprimée et toute la face arrière de chaque composant étant en contact avec une plaque de refroidissement commune à tous les composants intégrés, caractérisé en ce que la carte imprimée est souple et est pressée avec les composants intégrés (1) contre la plaque de refroidissement (3) par des moyens de pression (4) qui agissent sur toute sa surface, et que l'application des différents composants intégrés (1) contre la plaque de refroidissement commune est produite par dès éléments élastiques (5) placés chacun entre la carte imprimée souple (2) et un composant intégré (1).

2. Dispositif selon la revendication 1, caractérisé en ce qu'une pièce de remplissage élastique (5) est placée entre chaque composant intégré et la carte imprimée souple.

3. Dispositif selon la revendication 2, caractérisé en ce que la pièce de remplissage élastique (5) est en caoutchouc.

4. Dispositif selon une des revendications 1 à 3, caractérisé en ce que de la graisse conductrice (6) est disposée entre les composants intégrés et la plaque de refroidissement.

5. Dispositif selon une des revendication 1 à 4, caractérisé en ce que les espaces intermédiaires autour des composants intégrés (1), entre la plaque imprimée souple (2) et la plaque de refroidissement (3), sont remplis de matériau de remplissage élastique (7).

6. Dispositif selon la revendication 5, caractérisé en ce que du silicone est utilisé en tant que matériau de remplissage élastique.

7. Dispositif selon la revendication 5 ou 6, caractérisé en ce que le matériau de remplissage élastique est réalisé sous forme de gabarits élastiques.

# FIG 1

# FIG 2